# EUROPEAN PATENT APPLICATION

(11) **EP 4 675 294 A1**
(43) Date of publication of application: **07.01.2026**
(21) Application number: 24898145.8
(22) Date of filing: 28.11.2024
(51) Int. Cl.: G01R 31/392, G01R 31/382, G01R 31/396, G01R 31/367, G01R 19/165, G01R 19/30, H01M 10/0525

(54) **APPARATUS AND METHOD FOR DIAGNOSING BATTERY**

(30) Priority: 01.12.2023 KR 20230172711
(71) Applicant: LG Energy Solution, Ltd., Seoul 07335 (KR)
(72) Inventor: CHA, A-Ming, Daejeon 34122 (KR); BAE, Yoon-Jung, Daejeon 34122 (KR); KIM, Yong-Jun, Daejeon 34122 (KR)
(74) Representative: Goddar, Heinz J.
(86) International application number: PCT/KR2024/019090
(87) International publication number: WO 2025/116551

(57) **Abstract**

An apparatus for diagnosing a battery according to the present disclosure includes a profile obtaining unit configured to obtain a first differential profile based on a differential voltage and capacity of the battery corresponding to a charging process and a second differential profile based on a differential voltage and capacity of the battery corresponding to a discharging process; and a control unit configured to calculate the number of charging peaks included in a first capacity section from the first differential profile, calculate the number of discharging peaks included in a second capacity section from the second differential profile, and diagnose a state of the battery based on the number of the charging peaks and the discharging peaks.

## Description

### TECHNICAL FIELD

This application is based on and claims priority from Korean Patent Application No. 10-2023-0172711, filed on December 1, 2023, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery based on the number of peaks.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing an apparatus and method for diagnosing a battery, which diagnoses a state of a battery based on the number of peaks.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a first differential profile based on a differential voltage and capacity of the battery corresponding to a charging process and a second differential profile based on a differential voltage and capacity of the battery corresponding to a discharging process; and a control unit configured to calculate the number of charging peaks included in a first capacity section from the first differential profile, calculate the number of discharging peaks included in a second capacity section from the second differential profile, and diagnose a state of the battery based on the number of the charging peaks and the discharging peaks.

The control unit may be configured to compare the total number of the charging peaks and the discharging peaks with a preset reference number and diagnose the state of the battery based on the comparison result.

The control unit may be configured to diagnose the state of the battery as a BOL state, a MOL state or an EOL state based on the comparison result.

The control unit may be configured to diagnose the state of the battery as the BOL state when the total number is greater than or equal to a preset first reference number.

The control unit may be configured to diagnose the state of the battery as the MOL state when the total number is less than the first reference number and exceeds a preset second reference number.

The control unit may be configured to diagnose the state of the battery as the MOL state or the EOL state when the total number is equal to the second reference number.

The control unit may be configured to calculate the capacity of the battery when the total number is equal to the second reference number, compare the calculated capacity with a preset reference capacity, and diagnose the state of the battery as the MOL state or the EOL state based on the comparison result.

The control unit may be configured to calculate a ratio of the calculated capacity to the reference capacity.

The control unit may be configured to diagnose the state of the battery as the MOL state when the calculated ratio is greater than or equal to a preset reference ratio.

The control unit may be configured to diagnose the state of the battery as the EOL state when the calculated ratio is less than the reference ratio.

The control unit may be configured to calculate the capacity of the battery based on the second differential profile.

The control unit may be configured to determine a first capacity corresponding to a lowest differential voltage in the first differential profile, and set a capacity section smaller than or equal to the determined first capacity as the first capacity section.

The control unit may be configured to determine a second capacity corresponding to a highest differential voltage in the second differential profile, and set a capacity section greater than or equal to the determined second capacity as the second capacity section.

The control unit may be configured to divide the entire capacity section of the battery into a lower capacity section and an upper capacity section, determine the first capacity in the lower capacity section of the first differential profile, and determine the second capacity in the upper capacity section of the second differential profile.

A battery pack according to another aspect of the present disclosure may comprise the apparatus for diagnosing a battery according to one aspect of the present disclosure.

A method for diagnosing a battery according to still another aspect of the present disclosure may comprise a profile obtaining step of obtaining a first differential profile based on a differential voltage and capacity of the battery corresponding to a charging process and a second differential profile based on a differential voltage and capacity of the battery corresponding to a discharging process; a peak number calculating step of calculating the number of charging peaks included in a first capacity section from the first differential profile and calculating the number of discharging peaks included in a second capacity section from the second differential profile; and a battery diagnosing step of diagnosing a state of the battery based on the number of the charging peaks and the discharging peaks.

### Advantageous Effects

According to one aspect of the present disclosure, there is an advantage in that the state of the battery may be diagnosed even though additional measurement or inspection are not performed to diagnose the state of the battery.

In addition, according to one aspect of the present disclosure, since the state of the battery is diagnosed based on the number of charging and discharging peaks, there is an advantage in that the state of the battery may be diagnosed in a non-destructive manner.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a schematic drawing of a first differential profile of a battery according to an embodiment of the present disclosure.
FIG. 3 is a schematic drawing of a second differential profile of a battery according to an embodiment of the present disclosure.
FIG. 4 is a schematic drawing of a diagnostic example of a plurality of batteries according to an embodiment of the present disclosure.
FIG. 5 is a schematic drawing of a first differential profile of another battery according to an embodiment of the present disclosure.
FIG. 6 is a schematic drawing of a second differential profile of another battery according to an embodiment of the present disclosure.
FIG. 7 is a schematic drawing of an exemplary configuration of a battery pack including the apparatus for diagnosing a battery according to an embodiment of the present disclosure.
FIG. 8 is a diagram schematically showing a method for diagnosing a battery according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

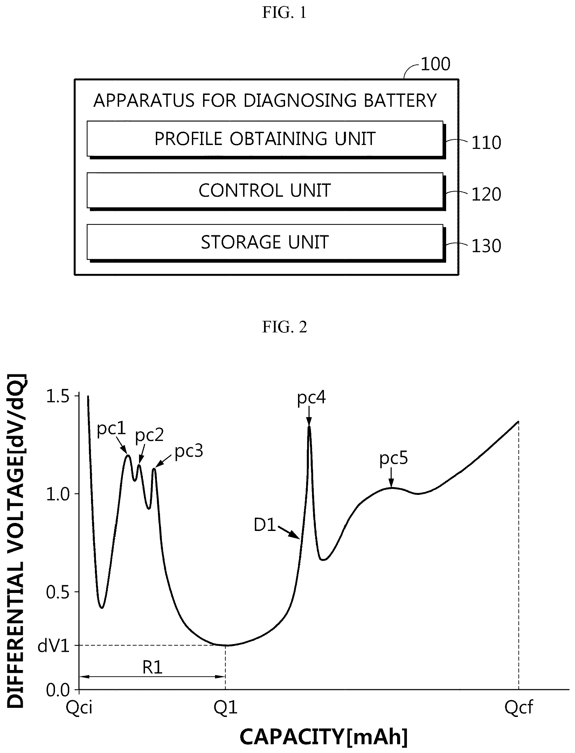

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110, a control unit 120, and a storage unit 130.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a first differential profile D1 based on the differential voltage and capacity of the battery corresponding to the charging process and a second differential profile D2 based on the differential voltage and capacity of the battery corresponding to the discharging process.

Specifically, the battery profile is a profile representing the corresponding relationship between the voltage (V) and the capacity (Q) of the battery. For example, the battery profile may be expressed as a two-dimensional graph in which the X-axis is set to the capacity and the Y-axis is set to the voltage. Then, when the battery profile is differentiated with respect to the capacity, a differential profile representing the corresponding relationship between the differential voltage (dV/dQ) and the capacity (Q) may be generated. Here, the differential voltage (dV/dQ) is a value obtained by differentiating the voltage (V) with respect to the capacity (Q), and may represent the instantaneous change rate of the voltage with respect to the capacity.

Here, there is no special limitation on the C-rate in charging or discharging for generating the battery profile. However, preferably, the battery should be charged or discharged at a low rate in order to obtain a more accurate battery profile and differential profile. For example, the battery profile may be generated in the process of charging or discharging the battery at 0.05 C.

The first differential profile D1 is a profile obtained by differentiating the battery profile generated in the charging process with respect to the capacity. Also, the second differential profile D2 is a profile obtained by differentiating the battery profile generated in the discharging process with respect to the capacity.

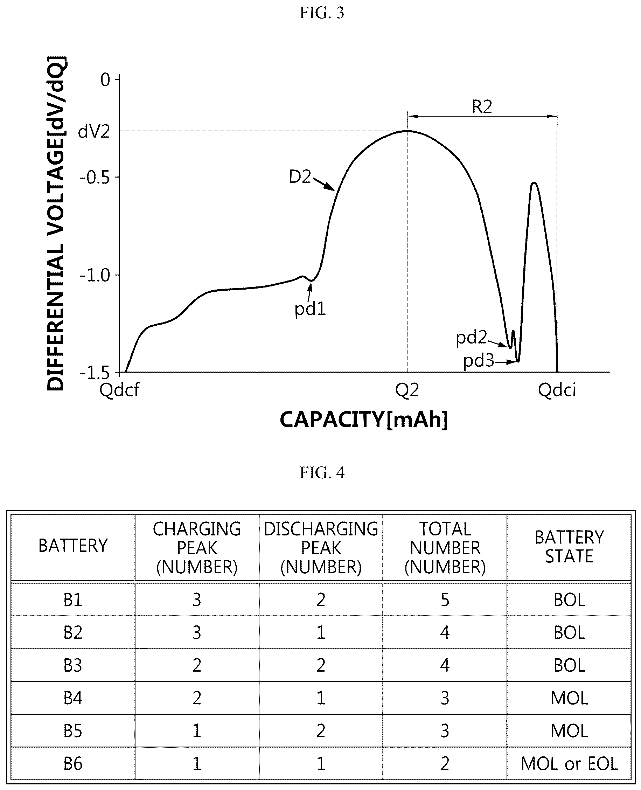

FIG. 2 is a schematic drawing of a first differential profile D1 of a battery according to an embodiment of the present disclosure. FIG. 3 is a schematic drawing of a second differential profile D2 of a battery according to an embodiment of the present disclosure. In the embodiments of FIGS. 2 and 3, when the sign of the charging direction is set to plus (+) and the sign of the discharging direction is set to minus (-), the differential voltage of the first differential profile D1 is expressed as a positive number, and the differential voltage of the second differential profile D2 is expressed as a negative number.

For example, the profile obtaining unit 110 may directly receive the first and second differential profiles D1, D2 of the battery from the outside. That is, the profile obtaining unit 110 may obtain the first and second differential profiles D1, D2 by being connected to the outside by wire and/or wirelessly and receiving the first and second differential profiles D1, D2.

As another example, the profile obtaining unit 110 may receive battery information about voltage and capacity of the battery. Here, the battery information may be divided into information corresponding to a charging process and information corresponding to a discharging process. In addition, the profile obtaining unit 110 may generate a first battery B1 profile corresponding to the charging process and a second battery B2 profile corresponding to the discharging process based on the received battery information. The profile obtaining unit 110 may generate a first differential profile D1 based on the first battery B1 profile, and may generate a second differential profile D2 based on the second battery B2 profile. That is, the profile obtaining unit 110 may obtain the first and second differential profiles D1, D2 by directly generating the first and second differential profiles D1, D2 based on the battery information.

The profile obtaining unit 110 may be connected to communicate with the control unit 120. For example, the profile obtaining unit 110 may be connected to the control unit 120 by wire and/or wirelessly. The profile obtaining unit may transmit the obtained first and second differential profiles D1, D2 to the control unit 120.

The control unit 120 may be configured to calculate the number of charging peaks included in the first capacity section R1 from the first differential profile D1.

Specifically, the first differential profile D1 may include a plurality of charging peaks. Here, the charging peak refers to a point having an upward convex shape among points where the instantaneous change rate of the differential voltage with respect to the capacity is 0. That is, the instantaneous change rate of the differential voltage with respect to the capacity on the low-capacity side is positive based on the charging peak, and the instantaneous change rate of the differential voltage with respect to the capacity on the high-capacity side is negative. The control unit 120 may calculate the number of charging peaks included in the first capacity section R1 among the plurality of charging peaks included in the first differential profile D1.

For example, in the embodiment of FIG. 2, the first differential profile D1 includes first to fifth charging peaks pc1, pc2, pc3, pc4, pc5. Also, the first capacity section R1 set for the first differential profile D1 includes first to third charging peaks pc1, pc2, pc3. Therefore, the control unit 120 may calculate the number of charging peaks included in the first capacity section R1 of the first differential profile D1 as 3.

The control unit 120 may be configured to calculate the number of discharging peaks included in the second capacity section R2 from the second differential profile D2.

Specifically, the second differential profile D2 may include a plurality of discharging peaks. Here, the discharging peak refers to a point having a downward convex shape among points where the instantaneous change rate of the differential voltage with respect to the capacity is 0. That is, the instantaneous change rate of the differential voltage with respect to the capacity on the low capacity side is negative based on the discharging peak, and the instantaneous change rate of the differential voltage with respect to the capacity on the high capacity side is positive. The control unit 120 may calculate the number of discharging peaks included in the second capacity section R2 among the plurality of discharging peaks included in the second differential profile D2.

For example, in the embodiment of FIG. 3, the second differential profile D2 includes first to third discharging peaks pd1, pd2, pd3. Also, the second capacity section R2 set for the second differential profile D2 includes the second and third discharging peaks pd2, pd3. Therefore, the control unit 120 may calculate the number of discharging peaks included in the second capacity section R2 of the second differential profile D2 as 2.

The control unit 120 may be configured to diagnose the state of the battery based on the number of charging peaks and discharging peaks.

Specifically, the control unit 120 may be configured to compare the total number of charging peaks and discharging peaks with a preset reference number.

Here, the reference number may be a value preset to correspond to the state of the battery.

For example, in the embodiments of FIGS. 2 and 3, the number of charging peaks is 3 and the number of discharging peaks is 2. The control unit 120 may compare the total number (5) of charging peaks and discharging peaks with a preset reference number. Specifically, the control unit 120 may compare the sizes of the total number (5) and the reference number.

The control unit 120 may be configured to diagnose the state of the battery based on the comparison result.

Specifically, the control unit 120 may be configured to diagnose the state of the battery as a BOL (Beginning of life) state, a MOL (Middle of life) state, or an EOL (End of life) state.

The BOL state refers to the initial state of the battery. The state of a battery in which the charging and discharging cycles have been performed within a certain number of cycles may correspond to the BOL state. In one embodiment, the state of a battery in which the charging and discharging cycles have been performed within about 10 cycles may be the BOL state.

The MOL state refers to a state in which the battery deteriorates as it is used. In other words, the MOL state is a state in which no problems are expected to occur even if the battery continues to be used.

The EOL state refers to a state in which the battery has deteriorated significantly and it is recommended to stop using it. For example, a battery with an SOH (state of health) of less than 80% may be called an EOL state. If a battery in the EOL state is continuously used, unexpected problems such as sudden death and venting may occur, so it is recommended to stop the use of the battery( 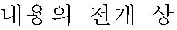 stop 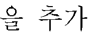 ).

That is, the apparatus 100 for diagnosing a battery may diagnose the state of the battery as a BOL state, a MOL state, or an EOL state by using a relatively simple method of comparing the total number of charging peaks and discharging peaks with the size of the reference number. That is, according to the apparatus 100 for diagnosing a battery, there is an advantage in that the state of the battery may be diagnosed even without additional measurement or inspection to diagnose the state of the battery. In addition, since the state of the battery is diagnosed according to the number of charging and discharging peaks, the apparatus 100 for diagnosing a battery has an advantage in that the state of the battery may be diagnosed in a non-destructive manner.

Meanwhile, the profile obtaining unit 110 and the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

A plurality of reference numbers may be preset. Then, the control unit 120 may compare the total number and the plurality of reference numbers, and diagnose the state of the battery based on the comparison result.

Here, the state of the battery may be distinguished by each of the plurality of reference numbers. Therefore, preferably, the number of preset reference numbers may be smaller than the number of states of the diagnosed battery. For example, if the number of states of the diagnosed battery is 3, the number of preset reference numbers may be 2. That is, the first reference number and the second reference number may be preset.

Also, the first capacity section R1 of the first differential profile D1 may include at least one charging peak, and the second capacity section R2 of the second differential profile D2 may include at least one discharging peak. Therefore, the minimum value of the total number may be 2. That is, one of the plurality of reference numbers may be set so as to distinguish the state of the battery corresponding to the minimum value of the total number.

In the following, it is assumed that the first reference number is set to 4 and the second reference number is set to 2. In addition, it is explained that the control unit 120 diagnoses the state of the battery as a BOL state, a MOL state, or an EOL state based on the result of comparing the total number with the first reference number and the second reference number. Here, it may be said that the second reference number is preset to distinguish the state of the battery corresponding to the minimum value of the total number.

For example, if the total number is greater than or equal to the preset first reference number, the control unit 120 may diagnose the state of the battery as a BOL state. As another example, if the total number is less than the first reference number and exceeds the preset second reference number, the control unit 120 may diagnose the state of the battery as a MOL state. As another example, if the total number is equal to the second reference number, the control unit 120 may diagnose the state of the battery as a MOL state or an EOL state.

FIG. 4 is a schematic drawing of a diagnostic example of a plurality of batteries according to an embodiment of the present disclosure.

Specifically, the first battery B1 has 3 charging peaks and 2 discharging peaks, and the total number is 5. The second battery B2 has 3 charging peaks and 1 discharging peak, and the total number is 4. The third battery B3 has 2 charging peaks and 2 discharging peaks, and the total number is 4. The fourth battery B4 has 2 charging peaks and 1 discharging peak, and the total number is 3. The fifth battery B5 has 1 charging peak and 2 discharging peaks, and the total number is 3. The sixth battery B6 has 1 charging peak and 1 discharging peak, and the total number is 2.

The total number of the first battery B1 is 5, which is greater than or equal to the first reference number (4). Therefore, the control unit 120 may diagnose the state of the first battery B1 as the BOL state.

The total number of the second battery B2 and the third battery B3 is 4, which is greater than or equal to the first reference number (4). Therefore, the control unit 120 may diagnose the state of the second battery B2 and the third battery B3 as the BOL state.

The total number of the fourth battery B4 and the fifth battery B5 is 3, which is less than the first reference number (4) and exceeds the second reference number (2). Therefore, the control unit 120 may diagnose the state of the fourth battery B4 and the fifth battery B5 as the MOL state.

The total number of the sixth battery B6 is 2, which is the same as the second reference number (2). Therefore, the control unit 120 may diagnose the state of the sixth battery B6 as the MOL state or the EOL state. That is, when the total number of the battery is 2, the state of the battery cannot be accurately distinguished only by the number of charging peaks and discharging peaks. In this case, the control unit 120 may diagnose the state of the battery as the MOL state or the EOL state by further considering the capacity of the battery.

The control unit 120 may be configured to calculate the capacity of the battery if the total number is equal to the second reference number.

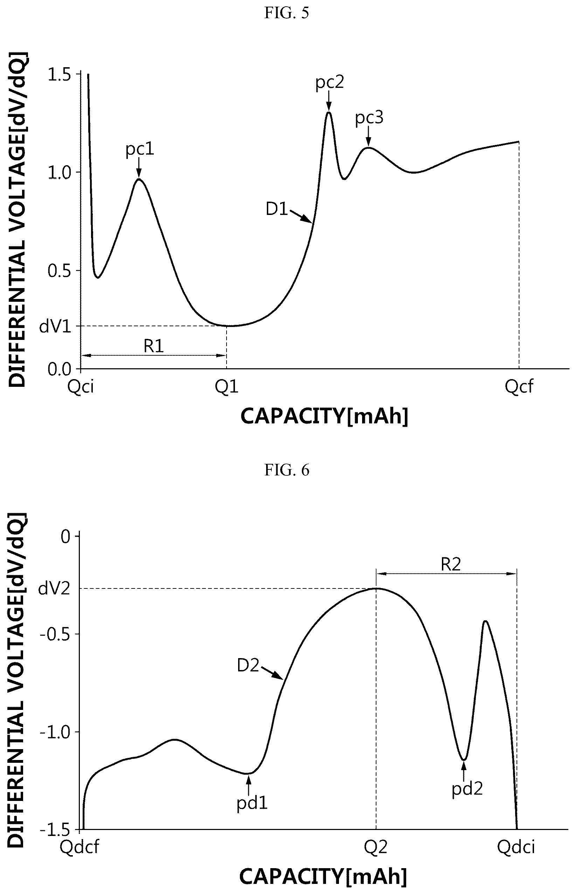

FIG. 5 is a schematic drawing of a first differential profile D1 of another battery according to an embodiment of the present disclosure. FIG. 6 is a schematic drawing of a second differential profile D2 of another battery according to an embodiment of the present disclosure. In the embodiments of FIGS. 5 and 6, when the sign of the charging direction is set to plus (+) and the sign of the discharging direction is set to minus (-), the differential voltage of the first differential profile D1 is expressed as a positive number, and the differential voltage of the second differential profile D2 is expressed as a negative number.

In the embodiment of FIG. 5, the first differential profile D1 includes the first to third charging peaks pc1, pc2, pc3, but the first capacity section R1 includes only the first charging peak pc1. That is, the number of charging peaks is 1.

In the embodiment of FIG. 6, the second differential profile D2 includes the first discharging peak pd1 and the second discharging peak pd2, but the second capacity section R2 includes only the second discharging peak pd2. That is, the number of discharging peaks is 1.

In the embodiments of FIGS. 5 and 6, since the total number of charging peaks and discharging peaks is equal to the second reference number (2), the control unit 120 may calculate the capacity of the battery to specifically diagnose the state of the battery.

Specifically, the control unit 120 may calculate the capacity of the battery based on the first differential profile D1 and/or the second differential profile D2.

For example, in the embodiment of FIG. 5, in the first differential profile D1, the charging start capacity of the battery is Qci, and the charging end capacity is Qcf. The control unit 120 may calculate the capacity of the battery based on the difference (Qcf - Qci) between the charging end capacity and the charging start capacity.

As another example, in the embodiment of FIG. 6, in the second differential profile D2, the discharging start capacity of the battery is Qdci, and the discharging end capacity is Qdcf. The control unit 120 may calculate the capacity of the battery based on the difference (Qdci - Qdcf) between the discharging start capacity and the discharging end capacity.

As another example, the control unit 120 may calculate the capacity of the battery by calculating the median value of the capacity calculated based on the first differential profile D1 and the capacity calculated based on the second differential profile D2.

The control unit 120 may be configured to compare the calculated capacity with a preset reference capacity.

Specifically, the control unit 120 may be configured to calculate a ratio of the calculated capacity to a reference capacity. Here, the reference capacity may be preset to an initial capacity of the battery. For example, the reference capacity may be preset to a design capacity of the battery.

The control unit 120 may calculate the ratio of the calculated capacity to the reference capacity by calculating the formula of "calculated capacity ÷ reference capacity". In this case, the calculation result may be included in a range of 0 to 1. In addition, the control unit 120 may also calculate the ratio of the calculated capacity to the reference capacity as a percentage. That is, the control unit 120 may estimate the SOH of the battery based on the calculated capacity and the reference capacity.

In addition, the control unit 120 may be configured to diagnose the state of the battery as a MOL state or an EOL state depending on the comparison result.

Specifically, the control unit 120 may compare the comparison result (the ratio of the calculated capacity to the reference capacity) with a preset reference ratio. Here, the reference ratio may be preset as a value of the ratio that may distinguish the state of the battery into a MOL state and an EOL state. For example, the reference ratio may be preset to 80%.

For example, if the calculated ratio is greater than or equal to the preset reference ratio, the control unit 120 may diagnose the state of the battery as a MOL state. As another example, if the calculated ratio is less than the reference ratio, the control unit 120 may diagnose the state of the battery as an EOL state.

The apparatus 100 for diagnosing a battery may primarily diagnose the state of a battery based on the number of peaks, and secondarily diagnose the state of the battery based on the capacity of the battery. In other words, the state of a battery may be specifically diagnosed by considering the number of peaks and the capacity.

Preferably, the control unit 120 may be configured to calculate the capacity of the battery based on the second differential profile D2. Ideally, the charging capacity and the discharging capacity of the battery are the same, but depending on the electrochemical characteristics of the battery, the charging capacity and the discharging capacity differ. This phenomenon is called hysteresis.

In determining the life performance of a battery, the discharging performance (i.e., discharging capacity), which is how much energy the battery may release, may be considered a more important factor than the charging performance (i.e., charging capacity), which is how much energy the battery may store.

Therefore, if the control unit 120 cannot diagnose the state of the battery with only the total number of charging peaks and discharging peaks, it may diagnose the state of the battery more specifically by considering the discharging capacity of the battery based on the second differential profile D2.

Below, an embodiment of setting the first capacity section R1 and the second capacity section R2 is specifically described.

The control unit 120 may be configured to determine the first capacity (Q1) corresponding to the lowest differential voltage in the first differential profile D1.

For example, in the embodiment of FIG. 2, the lowest differential voltage of the first differential profile D1 is dV1. The control unit 120 may determine the first capacity (Q1) corresponding to the lowest differential voltage dV1 as Q1.

In addition, the control unit 120 may be configured to set a capacity section less than or equal to the determined first capacity (Q1) as the first capacity section R1.

For example, in the embodiment of FIG. 2, the control unit 120 may set the Qci to Q1 section to the first capacity section R1. Then, the control unit 120 may calculate the number of charging peaks included in the first capacity section R1.

The control unit 120 may be configured to determine the second capacity (Q2) corresponding to the highest differential voltage in the second differential profile D2.

For example, in the embodiment of FIG. 3, the highest differential voltage of the second differential profile D2 is dV2. The control unit 120 may determine the second capacity (Q2) corresponding to the highest differential voltage dV2 as Q2.

The control unit 120 may be configured to set a capacity section greater than or equal to the determined second capacity (Q2) as the second capacity section R2.

For example, in the embodiment of FIG. 3, the control unit 120 may set the Q2 to Qdci sections to the second capacity section R2. Also, the control unit 120 may calculate the number of discharging peaks included in the second capacity section R2.

Specifically, the charging peak of the first differential profile D1 is a peak that has an upward convex shape. Also, the point corresponding to the lowest differential voltage is a point that has a downward convex shape. That is, the charging peak used to diagnose the state of the battery is included in the low-capacity side from the point corresponding to the lowest differential voltage.

In addition, the discharging peak of the second differential profile D2 is a peak that has a downward convex shape. Also, the point corresponding to the highest differential voltage is a point that has an upward convex shape. In other words, the discharging peak used to diagnose the state of the battery is included in the high-capacity side from the point corresponding to the highest differential voltage.

Therefore, the control unit 120 may calculate the number of charging peaks by considering only the first capacity section R1 of the first differential profile D1, and may calculate the number of discharging peaks by considering only the second capacity section R2 of the second differential profile D2.

That is, since a process of separately selecting the charging peak and the discharging peak after calculating all peaks in the entire capacity section is not required, the apparatus 100 for diagnosing a battery has the advantage of being able to diagnose the state of the battery more quickly and saving system resources consumed in diagnosing the state of the battery.

Meanwhile, the control unit 120 may be configured to divide the entire capacity section of the battery into a lower capacity section and an upper capacity section.

For example, in the embodiment of FIG. 2, the entire capacity section is a Qci to Qcf section. The control unit 120 may divide the entire capacity section into two parts, namely dividing the lower capacity section into a Qci to (Qcf-Qci)÷2 section and the upper capacity section into a (Qcf-Qci)÷2 to Qcf section.

As another example, in the embodiment of FIG. 3, the entire capacity section is a Qdcf to Qdci section. The control unit 120 may divide the entire capacity section into two parts, namely dividing the lower capacity section into a Qdcf to (Qdci-Qdcf)÷2 section and the upper capacity section into a (Qdci-Qdcf)÷2 to Qdci section.

The control unit 120 may be configured to determine the first capacity (Q1) in the lower capacity section of the first differential profile D1 and determine the second capacity (Q2) in the upper capacity section of the second differential profile D2.

Generally, the point corresponding to the lowest differential voltage in the first differential profile D1 is included in the lower capacity section, and the point corresponding to the highest differential voltage in the second differential profile D2 is included in the upper capacity section. Therefore, the control unit 120 may determine the first capacity (Q1) in the lower capacity section of the first differential profile D1 and determine the second capacity (Q2) in the upper capacity section of the second differential profile D2, thereby determining the first capacity (Q1) and the second capacity (Q2) more quickly.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

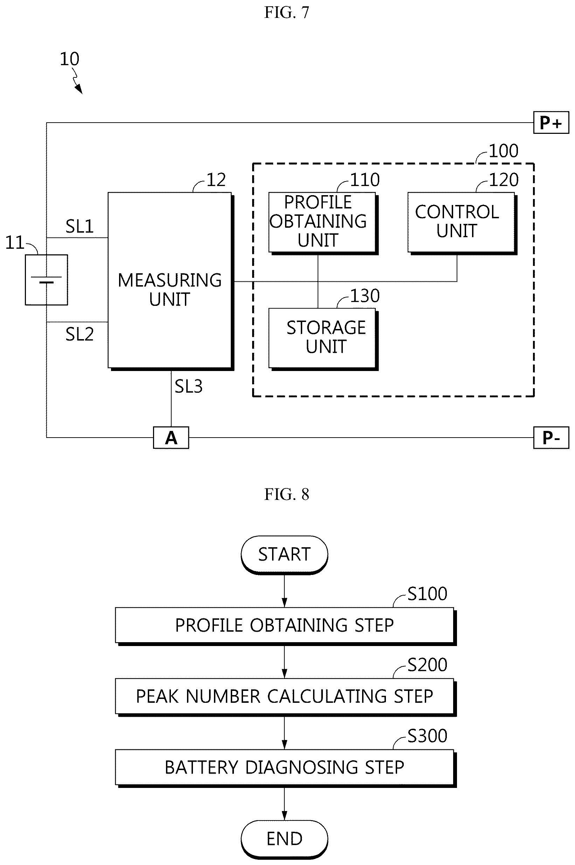

FIG. 7 is a schematic drawing of an exemplary configuration of a battery pack including the apparatus for diagnosing a battery according to an embodiment of the present disclosure.

The positive electrode terminal of the battery 11 may be connected to the positive electrode terminal P+ of the battery pack 1, and the negative electrode terminal of the battery 11 may be connected to the negative electrode terminal P- of the battery pack 1.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

The load 2 may have one end connected to the positive electrode terminal P+ of the battery pack 1, and the other end connected to the negative electrode terminal P- of the battery pack 1. Accordingly, the positive electrode terminal of the battery 11, the positive electrode terminal P+ of the battery pack 1, the load 2, the negative electrode terminal P- of the battery pack 1, and the negative electrode terminal of the battery 11 may be electrically connected.

FIG. 8 is a diagram schematically showing a method for diagnosing a battery according to another embodiment of the present disclosure.

Referring to FIG. 8, the method for diagnosing a battery may include a profile obtaining step (S100), a peak number calculating step (S200), and a battery diagnosing step (S300).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a first differential profile D1 based on the differential voltage and capacity of the battery corresponding to the charging process and a second differential profile D2 based on the differential voltage and capacity of the battery corresponding to the discharging process, and may be performed by the profile obtaining unit 110.

For example, the profile obtaining unit 110 may directly receive the first and second differential profiles D1, D2 of the battery from the outside. That is, the profile obtaining unit 110 may obtain the first and second differential profiles D1, D2 by being connected to the outside by wire and/or wirelessly and receiving the first and second differential profiles D1, D2.

As another example, the profile obtaining unit 110 may receive battery information about the voltage and capacity of the battery. Here, the battery information may be divided into information corresponding to a charging process and information corresponding to a discharging process. In addition, the profile obtaining unit 110 may obtain the first and second differential profiles D1, D2 by directly generating the first and second differential profiles D1, D2 based on the battery information.

The peak number calculating step (S200) is a step of calculating the number of charging peaks included in the first capacity section R1 from the first differential profile D1 and calculating the number of discharging peaks included in the second capacity section R2 from the second differential profile D2, and may be performed by the control unit 120.

For example, in the embodiment of FIG. 2, the control unit 120 may calculate the number of charging peaks included in the first capacity section R1 of the first differential profile D1 as 3.

For example, in the embodiment of FIG. 3, the control unit 120 may calculate the number of discharging peaks included in the second capacity section R2 of the second differential profile D2 as 2.

The battery diagnosing step (S300) is a step for diagnosing the state of the battery based on the number of charging peaks and discharging peaks, and may be performed by the control unit 120.

Specifically, the control unit 120 may be configured to compare the total number of charging peaks and discharging peaks with a preset reference number, and diagnose the state of the battery as a BOL state, a MOL state, or an EOL state based on the comparison result.

For example, in the embodiments of FIGS. 2 and 3, the total number of charging peaks and discharging peaks is 5. The control unit 120 may diagnose the state of the battery as a BOL state by comparing the total number and the reference number.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: apparatus for diagnosing a battery
110: profile obtaining unit
120: control unit
130: storage unit

## Claims

1. An apparatus for diagnosing a battery, comprising:
a profile obtaining unit configured to obtain a first differential profile based on a differential voltage and capacity of the battery corresponding to a charging process and a second differential profile based on a differential voltage and capacity of the battery corresponding to a discharging process; and
a control unit configured to calculate the number of charging peaks included in a first capacity section from the first differential profile, calculate the number of discharging peaks included in a second capacity section from the second differential profile, and diagnose a state of the battery based on the number of the charging peaks and the discharging peaks.

2. The apparatus for diagnosing a battery according to claim 1,
wherein the control unit is configured to compare the total number of the charging peaks and the discharging peaks with a preset reference number and diagnose the state of the battery based on the comparison result.

3. The apparatus for diagnosing a battery according to claim 2,
wherein the control unit is configured to diagnose the state of the battery as a BOL state, a MOL state or an EOL state based on the comparison result.

4. The apparatus for diagnosing a battery according to claim 2,
wherein the control unit is configured to:
diagnose the state of the battery as the BOL state when the total number is greater than or equal to a preset first reference number,
diagnose the state of the battery as the MOL state when the total number is less than the first reference number and exceeds a preset second reference number, and
diagnose the state of the battery as the MOL state or the EOL state when the total number is equal to the second reference number.

5. The apparatus for diagnosing a battery according to claim 4,
wherein the control unit is configured to calculate the capacity of the battery when the total number is equal to the second reference number, compare the calculated capacity with a preset reference capacity, and diagnose the state of the battery as the MOL state or the EOL state based on the comparison result.

6. The apparatus for diagnosing a battery according to claim 5,
wherein the control unit is configured to:
calculate a ratio of the calculated capacity to the reference capacity,
diagnose the state of the battery as the MOL state when the calculated ratio is greater than or equal to a preset reference ratio, and
diagnose the state of the battery as the EOL state when the calculated ratio is less than the reference ratio.

7. The apparatus for diagnosing a battery according to claim 5,
wherein the control unit is configured to calculate the capacity of the battery based on the second differential profile.

8. The apparatus for diagnosing a battery according to claim 1,
wherein the control unit is configured to:
determine a first capacity corresponding to a lowest differential voltage in the first differential profile, and set a capacity section smaller than or equal to the determined first capacity as the first capacity section, and
determine a second capacity corresponding to a highest differential voltage in the second differential profile, and set a capacity section greater than or equal to the determined second capacity as the second capacity section.

9. The apparatus for diagnosing a battery according to claim 8,
wherein the control unit is configured to divide the entire capacity section of the battery into a lower capacity section and an upper capacity section, determine the first capacity in the lower capacity section of the first differential profile, and determine the second capacity in the upper capacity section of the second differential profile.

10. A battery pack, comprising the apparatus for diagnosing a battery according to any one of claims 1 to 9.

11. A method for diagnosing a battery, comprising:
a profile obtaining step of obtaining a first differential profile based on a differential voltage and capacity of the battery corresponding to a charging process and a second differential profile based on a differential voltage and capacity of the battery corresponding to a discharging process;
a peak number calculating step of calculating the number of charging peaks included in a first capacity section from the first differential profile and calculating the number of discharging peaks included in a second capacity section from the second differential profile; and
a battery diagnosing step of diagnosing a state of the battery based on the number of the charging peaks and the discharging peaks.
